# EUROPÄISCHE PATENTANMELDUNG

(11) **EP 4 239 888 A2**
(43) Veröffentlichungstag der Anmeldung: **06.09.2023**
(21) Anmeldenummer: 23183650.3
(22) Anmeldetag: 07.05.2018
(51) Int. Cl.: H03K 17/06, H03K 17/16, H02M 1/08, H02M 1/32, H02H 3/087, H01L 27/092, H02H 9/00, H03K 17/0412, H01L 27/07

(54) **VORRICHTUNG ZUR ANSTEUERUNG EINER ELEKTRONISCHEN SICHERUNG FÜR MINDESTENS EINEN ELEKTRISCHEN VERBRAUCHER INSBESONDERE EINES FAHRZEUGS**

(30) Priorität: 05.05.2017 EP 17169691
(62) Teilanmeldung aus: 18171089.8
(71) Anmelder: Elmos Semiconductor SE, 44227 Dortmund (DE)
(72) Erfinder: Sudhaus, Andre, 44227 Dortmund (DE)
(74) Vertreter: dompatent von Kreisler Selting Werner - Partnerschaft von Patent- und Rechtsanwälten mbB

(57) **Zusammenfassung**

Die elektronische Sicherung für mindestens einen elektrischen Verbraucher ist versehen mit mindestens einem Unterbrechungs-Halbleiterschalter (12) und einem Treiber (16) für den Unterbrechungs-Halbleiterschalter (12). Der Treiber (16) ist versehen mit einem Highside-Schalter (20), der zwischen einem Versorgungspotential (V₁) und dem Ausgangsanschluss (28) des Treibers (16) geschaltet ist, und mit einer zwischen dem Ausgangsanschluss (28) und Masse (42) geschalteten Einheit (40) zur zwecks Öffnen des Unterbrechungs-Halbleiterschalters (12) erfolgenden Ableitung eines Stroms von der Ansteuerelektrode (14) des Unterbrechungs-Halbleiterschalters (12). Ferner beinhaltet die Vorrichtung mindestens eine Störunterdrückungs-Bauteilanordnung (SB) zur Verhinderung einer den Betrieb des Unterbrechungs-Halbleiterschalters (12) beeinträchtigenden und insbesondere ein ungewolltes Öffnen des Unterbrechungs-Halbleiterschalters (12) verursachenden Potentialveränderung, insbesondere Mittelwertverschiebung, am Ausgangsanschluss (28) des Treibers (16) als Folge von unsymmetrischen Reaktionen des Treibers (16) auf Störsignale, die über die Versorgungsleitung (34) des Verbrauchers einkoppelbar sind und/oder in der Versorgungsleitung (34) des Verbrauchers entstehen.

## Beschreibung

Die Erfindung betrifft eine elektronische Sicherung für mindestens einen elektrischen Verbraucher, insbesondere für mindestens einen elektrischen Verbraucher eines Fahrzeugs. Ferner betrifft die Erfindung eine Vorrichtung zur Ansteuerung einer elektronischen Sicherung für mindestens einen elektrischen Verbraucher, insbesondere für mindestens einen elektrischen Verbraucher eines Fahrzeugs.

Es ist bekannt, in einem Fahrzeug für einzelne elektrische Verbraucher Sicherungen vorzusehen. Während früher im Regelfall Schmelzsicherungen eingesetzt wurden, verwendet man heutzutage elektronische Sicherungen, also Unterbrechungs-Halbleiterschalter, die dann, wenn keine Störung am Verbraucher vorliegt, eingeschaltet sind und im Falle einer Störung geöffnet werden. Der Unterbrechungs-Halbleiterschalter ist in die Versorgungsleitung eines Verbrauchers geschaltet, wobei sein steuerbarer Strompfad im Regelfall in Reihe mit dem Verbraucher liegt. Die Unterbrechungs-Halbleiterschalter verfügen über eine Ansteuerelektrode, die elektrisch mit dem Ausgangsanschluss eines Treibers verbunden ist. Im Falle einer Störung des Verbrauchers wird der Treiber dergestalt angesteuert, dass der zuvor geschlossene Unterbrechungs-Halbleiterschalter geöffnet wird.

Ein potentielles Problem bei derartigen elektronischen Sicherungen besteht darin, dass Störsignale, die leitungsgebunden oder drahtlos in die Versorgungsleitung eingespeist werden, über die elektrische Verbindung der Ansteuerelektrode des Unterbrechungs-Halbleiterschalters und den Treiber in diesen gelangen und dort Fehlfunktionen auslösen können. Diese Fehlfunktionen können dazu führen, dass der Treiber die DC-Ansteuerspannung für den Unterbrechungs-Halbleiterschalter nicht mehr zur Verfügung stellt, woraufhin dann der Unterbrechungs-Halbleiterschalter beispielsweise unbeabsichtigt öffnet.

Aufgabe der Erfindung ist es, das Risiko für Fehlfunktionen elektronischer Sicherungen für elektrische Verbraucher von Fahrzeugen auf einfache Art und Weise zu vermeiden.

Die Erfindung dient der Verbesserung des Verhältnisses zwischen der Größe der Störungen und der Toleranz der Anordnung gegenüber diesen Störungen und schlägt zur Lösung der Aufgabe eine elektronische Sicherung für mindestens einen elektrischen Verbraucher eines insbesondere Fahrzeugs vor, wobei die elektronische Sicherung versehen ist mit
- mindestens einem Unterbrechungs-Halbleiterschalter zur Unterbrechung der Zufuhr elektrischer Energie über eine Versorgungsleitung zu einem Verbraucher im Falle einer Störung des Verbrauchers, wobei der Unterbrechungs-Halbleiterschalter eine Ansteuerelektrode aufweist, und
- einer Vorrichtung zur Ansteuerung des Unterbrechungs-Halbleiterschalters, die versehen ist mit
   - einem Treiber für den Unterbrechungs-Halbleiterschalter, wobei der Treiber einen elektrisch mit der Ansteuerelektrode des Unterbrechungs-Halbleiterschalters verbundenen Ausgangsanschluss zur Lieferung einer DC-Ansteuerspannung für den Unterbrechungs-Halbleiterschalter über eine zu dessen Ansteuerelektrode führende Ansteuerleitung aufweist,
   - wobei der Treiber ferner versehen ist mit einem Highside-Schalter, der zwischen einem Versorgungspotential und dem Ausgangsanschluss geschaltet ist, und mit einer zwischen dem Ausgangsanschluss und Masse geschalteten elektrischen und/oder elektronischen Einheit zur zwecks Öffnens des Unterbrechungs-Halbleiterschalters erfolgenden Ableitung eines Stroms von der Ansteuerelektrode des Unterbrechungs-Halbleiterschalters, und
   - mindestens einer elektrischen und/oder elektronischen Störunterdrückungs-Bauteilanordnung zur Verhinderung einer den Betrieb des Unterbrechungs-Halbleiterschalters beeinträchtigenden und insbesondere ein ungewolltes Öffnen des Unterbrechungs-Halbleiterschalters verursachenden Potentialveränderung, insbesondere Mittelwertverschiebung, am Ausgangsanschluss des Treibers als Folge von unsymmetrischen Reaktionen des Treibers auf Störsignale, die über die Versorgungsleitung des Verbrauchers einkoppelbar sind und/oder in der Versorgungsleitung des Verbrauchers entstehen.

Nach der Erfindung ist vorgesehen, die Ansteuerung des Unterbrechungs-Halbleiterschalters rückspeisefest zu gestalten. Durch die parasitäre kapazitive Kopplung der Ansteuerelektrode des Unterbrechungs-Halbleiterschalters zur Versorgungsleitung können Wechselstörsignale in der Versorgungsleitung oder in dieser von außen eingekoppelte Wechselstörsignale in die Ansteuerleitung eingekoppelt werden und damit an den Ausgangsanschluss des Treibers für den Unterbrechungs-Halbleiterschalter gelangen. Wegen des im Regelfall unsymmetrischen Aufbaus des Treibers (bei Betrachtung des Treibers von dessen Ausgangsanschluss) können derartige Wechselsignale im Mittel zu einer Verschiebung des DC-Potentials an der Ansteuerelektrode des Unterbrechungs-Halbleiterschalters bzw. am Ausgangsanschluss des Treibers führen. Diese Potentialverschiebung kann zu einem Ausschalten des Unterbrechungs-Halbleiterschalters führen, was unerwünscht ist. Daher ist nach der Erfindung mindestens eine elektrische und/oder elektronische Störunterdrückungs-Bauteilanordnung vorgesehen, und zwar zur Verhinderung einer den Betrieb des Unterbrechungs-Halbleiterschalters beeinträchtigenden und insbesondere ein ungewolltes Öffnen des Unterbrechungs-Halbleiterschalters verursachenden Potentialveränderung, insbesondere eine Mittelwertverschiebung, am Ausgangsanschluss des Treibers als Folge von unsymmetrischen Reaktionen des Treibers auf Störsignale, die über die Versorgungsleitung des Verbrauchers einkoppelbar sind und/oder in der Versorgungsleitung des Verbrauchers entstehen.

Aufgabe des Treibers ist es, die DC-Ansteuerspannung zum Schließen des Unterbrechungs-Halbleiterschalters zu liefern. Außerdem muss der Treiber dann, wenn eine Fehlfunktion des Verbrauchers festgestellt wird und die elektronische Sicherung ansprechen muss, die DC-Ansteuerspannung möglichst schnell soweit abzusenken, dass der Unterbrechungs-Halbleiterschalter öffnet. Insoweit ist der Treiber neben einem im Regelfall Highside-Schalter mit einer weiteren elektrischen bzw. elektronischen Einheit versehen, die zwischen den Ausgangsanschluss des Treibers und Masse geschaltet ist, um im Bedarfsfalle einen Stromfluss von der Ansteuerelektrode des Unterbrechungs-Halbleiterschalters nach Masse zu gewährleisten. Bei dieser Einheit (ggf. mit ESD-Schutzfunktion) kann es sich beispielsweise um einen Lowside-Schalter, um einen Widerstand oder aber auch um eine Stromquelle handeln. Weitere elektrische/elektronische Bauteile sind ebenfalls als die besagte Einheit einsetzbar.

Sinn und Zweck der erfindungsgemäß vorgesehenen Störunterdrückungs-Bauteilanordnung ist die Linearisierung der Kennlinie des Treibers für über dessen Ausgangsanschluss in den Treiber eingekoppelte AC-Störsignale bzw. - pegel.

Gemäß einer ersten Variante der Erfindung weist die Störunterdrückungs-Bauteilanordnung eine Kapazität zur Reduktion der Größe des Störsignals auf, wobei die Kapazität zwischen einerseits die zur Ansteuerelektrode des Unterbrechungs-Halbleiterschalters führenden Ansteuerleitung und andererseits entweder vorzugsweise die Versorgungsspannung oder optional die Masse geschaltet ist. Bei dieser Kapazität kann es sich um eine parasitäre Kapazität oder aber auch um ein zu diesem Zweck zusätzlich vorzusehendes Bauteil (im Regelfall Kondensator) handeln. Durch die Kapazität wird die Amplitude des Störsignals, das von außen bis zum Ausgangsanschluss des Treibers gelangt, reduziert, so dass der Treiber insoweit rückspeisefest bleibt, da die Größe des Störsignals zu gering ist, um Fehlfunktionen von Bauteilen des Treibers (hier insbesondere des Highside-Schalters) zu induzieren.

Gemäß einer weiteren Alternative der Erfindung ist vorgesehen, dass der Highside-Schalter ein PMOS-Transistor ist, der eine in einem Halbleitersubstrat ausgebildete n-dotierte n-Wanne mit einem Drain-Anschlussgebiet und einem Source-Anschlussgebiet aufweist und der mit einer Gate-Elektrode versehen ist. Bei einer derartigen Ausgestaltung des Highside-Schalters als PMOS-Transistor ist vorteilhafterweise vorgesehen, dass die Störunterdrückungs-Bauteilanordnung zwei als parasitäre Bauelemente z. B. des PMOS-Transistors und/oder als separat von diesem und damit zusätzliche Bauelemente ausgebildete Dioden aufweist, die hinsichtlich ihrer Sperrrichtungen gegensinnig in Reihe (d. h. antiseriell) geschaltet sind, wobei ihre Kathoden elektrisch miteinander sowie mit der n-Wanne des PMOS-Transistors verbunden sind. Die beiden Dioden können entweder als Dioden-Bauteile oder aber auch als Bauteile ausgeführt sein, die eine Diodenfunktion erfüllen, wie es beispielsweise bei einem entsprechend beschalteten Transistor der Fall ist. Die beiden Dioden können als integrierter Gleichrichter zur Wannenaufhängung des PMOS-Transistors aufgefasst werden (im Folgenden nur als "Wannenaufhängung" bezeichnet), die keinen Spannungsanstieg am Treiber über die Diodenspannungen hinaus erlauben. Der Vorteil der integrierten Wannenaufhängung besteht darin, dass kein Aufwand für externe vorzusehende Bauteile erforderlich ist.

Bei der zuvor beschriebenen Variante der Erfindung kann es von Vorteil sein, wenn mindestens eine der beiden Dioden als parasitäre Diode zwischen einerseits dem Drain-Anschlussgebiet oder dem Source-Anschlussgebiet und andererseits der n-Wanne des PMOS-Transistors ausgebildet oder wenn mindestens eine der beiden Dioden als Schottky-Dioden ausgeführt ist. Bei diesen Ausgestaltungen der Erfindung kann zusätzlich zweckmäßigerweise noch vorgesehen sein, dass parallel zu einer der beiden Dioden zwischen der n-Wanne und dem Versorgungspotential ein ohmscher Widerstand zur Vermeidung von funktionsbeeinträchtigenden Aufladungen der n-Wanne geschaltet ist oder dass alternativ parallel zu einer der beiden Dioden zwischen der n-Wanne und Masse ein ohmscher Widerstand zur Vermeidung von Aufladungen der n-Wanne geschaltet ist.

In weiterer zweckmäßiger Ausgestaltung der Erfindung kann dann, wenn der Highside-Schalter ein PMOS-Transistor ist, der eine in einem Halbleitersubstrat ausgebildete n-dotierte n-Wanne mit einem Drain-Anschlussgebiet und einem Source-Anschlussgebiet aufweist und der mit einer Gate-Elektrode versehen ist, vorgesehen sein, dass die Störunterdrückungs-Bauteilanordnung zur Erhöhung der Toleranz gegenüber Störsignalen, d. h. zur Erhöhung der Schaltschwelle bei Störsignalen eine Diode, insbesondere eine Schottky-Diode aufweist, deren Kathode mit der n-Wanne und deren Anode mit dem Source-Anschlussgebiet des PMOS-Transistors verbunden ist. Hierbei ist in zweckmäßiger Weiterführung vorgesehen, dass zur Begrenzung von Spannungshüben in der n-Wanne zwischen dieser und dem Source-Anschlussgebiet eine antiparallel zur Schottky-Diode angeordnete weitere Diode geschaltet ist.

In vorteilhafter Weiterbildung der Erfindung gemäß den beiden zuvor beschriebenen Varianten kann vorgesehen sein, dass zum DC-Potentialausgleich mit der Versorgungsspannung parallel zur Schottky-Diode ein Widerstand geschaltet ist.

In vorteilhafter Weise kann vorgesehen sein, dass der Highside-Schalter ein PMOS-Transistor ist, der eine in einem Halbleitersubstrat ausgebildete n-dotierte n-Wanne mit einem Drain-Anschlussgebiet und einem Source-Anschlussgebiet aufweist und der mit einer Gate-Elektrode versehen ist, und dass die Störunterdrückungs-Bauteilanordnung zwei Dioden aufweist, die hinsichtlich ihrer Sperrrichtungen gegensinnig in Reihe geschaltet sind, wobei ihre Kathoden elektrisch miteinander sowie mit der n-Wanne des PMOS-Transistors verbunden sind und dass die Störunterdrückungs-Bauteilanordnung eine Zener-Diode aufweist, deren Kathode mit der n-Wanne und deren Anode mit dem Drain-Anschlussgebiet des PMOS-Transistors verbunden ist.

Ferner ist es zweckmäßig, wenn der Highside-Schalter ein PMOS-Transistor ist, der eine in einem Halbleitersubstrat ausgebildete n-dotierte n-Wanne mit einem Drain-Anschlussgebiet und einem Source-Anschlussgebiet aufweist und der mit einer Gate-Elektrode versehen ist, und wenn die Störunterdrückungs-Bauteilanordnung zwei Dioden aufweist, die hinsichtlich ihrer Sperrrichtungen gegensinnig in Reihe geschaltet sind, wobei ihre Kathoden elektrisch miteinander sowie mit der n-Wanne des PMOS-Transistors verbunden sind.

Ferner kann es zweckmäßig sein, dass zwischen der n-Wanne des PMOS-Transistors und einem seiner Anschlüsse oder dem Versorgungspotential oder der Masse zur Vermeidung von funktionsbeeinträchtigenden Aufladungen der n-Wanne ein ohmscher Widerstand geschaltet ist. Dieser ohmsche Widerstand wirkt insofern statisch, als er eine Aufladung der n-Wanne verhindert. Dynamisch gesehen hat er im Wesentlichen keinen Einfluss auf das Potential am Ausgangsanschluss des Treibers. Der Widerstand sollte einen Wert aufweisen, der im zu betrachtenden Störfrequenzband einerseits viel größer als die Impedanz des PMOS-Transistors ist und andererseits das 1 bis 10-fache der vom Ausgangsanschluss des Treibers aus betrachteten Impedanz der Ansteuerleitung (mit ggf. ohmschem Widerstand) zum Unterbrechungs-Halbleiterschalter mit dessen parasitären Kapazitäten zwischen der Ansteuerelektrode und den Versorgungsleitungsverbindungspunkten des Unterbrechungs-Halbleiterschalters beträgt.

Bei einer weiteren Ausgestaltung der Erfindung kann vorgesehen sein, dass zwischen dem Ausgangsanschluss des Treibers und der n-Wanne des PMOS-Transistors eine Diode, insbesondere eine Schottky-Diode geschaltet ist, deren Kathode mit der n-Wanne des PMOS-Transistors verbunden ist.

Bei einer weiteren Alternative der Erfindung ist vorgesehen, dass der Highside-Schalter in Form zweier voneinander isolierter NMOS-Transistoren mit jeweils einer entweder parasitären Diode zwischen dem Drain-Anschlussgebiet und dem Source-Anschlussgebiet oder einer separat vorgesehenen Diode oder beidem ausgebildet ist, dass die Drain-Source-Strecke der beiden NMOS-Transistoren in Reihe miteinander geschaltet sind, wobei entweder die Drain-Anschlussgebiete oder die Source-Anschlussgebiete der beiden NMOS-Transistoren unter Bildung eines Verbindungspunkts miteinander verbunden sind und wobei die Dioden hinsichtlich ihrer Sperrrichtung gegensinnig sind und insbesondere ihre Kathoden miteinander sowie mit dem Verbindungspunkt der beiden NMOS-Transistoren verbunden sind.

Eine weitere Variante der Erfindung ist dadurch gekennzeichnet, dass in Reihe mit dem Highside-Schalter des Treibers mindestens eine Diode geschaltet ist, deren Kathode den Ausgangsanschluss des Treibers bildet, wobei die mindestens eine Diode einen aus Störsignalen potentiell resultierenden Stromfluss von der Ansteuerelektrode des Unterbrechungs-Halbleiterschalters zum Highside-Schalter und damit eine den Betrieb des Unterbrechungs-Halbleiterschalters beeinträchtigende und insbesondere ein ungewolltes Öffnen des Unterbrechungs-Halbeiterschalters verursachende Potentialverschiebung, insbesondere Mittelwertverschiebung, am Ausgangsanschluss des Treibers verhindert bzw. limitiert.

Unter anderem zur Strombegrenzung (aber auch im Zusammenhang mit dem Schutz vor großen Störungen zwischen Gate und Source eines als Unterbrechungs-Halbleiterschalters eingesetzten z. B. NMOS-Transistors) kann vorgesehen sein, dass in der vom Ausgangsanschluss des Treibers verlaufenden Ansteuerleitung zwischen der Störunterdrückungs-Bauteilanordnung und der Ansteuerelektrode des Unterbrechungs-Halbleiterschalters oder in der Störunterdrückungs-Bauteilanordnung oder im Treiber ein ohmscher Widerstand angeordnet ist.

Die Erfindung wird nachfolgend anhand mehrerer Ausführungsbeispiele und unter Bezugnahme auf die Zeichnung näher erläutert.

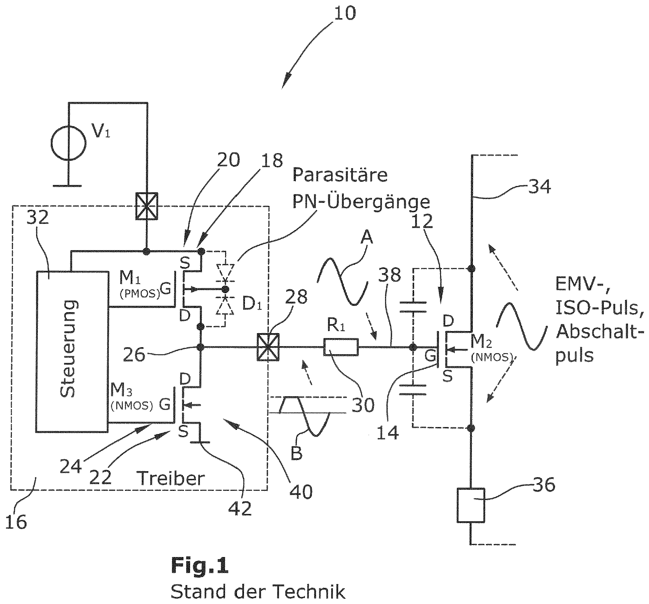

Fig. 1 zeigt die Situation hinsichtlich der Ansteuerung eines Unterbrechungs-Halbleiterschalters einer elektronischen Sicherung gemäß dem Stand der Technik, wobei keine Maßnahmen ergriffen sind, um die Ansteuerung der elektronischen Sicherung rückspeisefest auszuführen.

In Fig. 1 ist eine Vorrichtung 10 zur Ansteuerung einer elektronischen Sicherung für mindestens einen elektrischen Verbraucher, insbesondere in einem Fahrzeug gezeigt. Die elektronische Sicherung weist einen Unterbrechungs-Halbleiterschalter 12 auf, dessen Ansteuerelektrode 14 mittels eines Treibers 16 mit einer DC-Ansteuerspannung zum Schließen des Unterbrechungs-Halbleiterschalters 12 angesteuert wird. Der Treiber 16 weist in diesem Ausführungsbeispiel einen PMOS-Transistor 18 als Highside-Schalter 20 und einen NMOS-Transistor 22 als Lowside-Schalter 24 auf. Der Verbindungsknoten 26 beider Schalter bildet den Ausgangsanschluss 28 des Treibers 16, der über einen der Strombegrenzung dienenden Widerstand 30 mit der Ansteuerelektrode 14 des Unterbrechungs-Halbleiterschalters 12 verbunden ist. Die beiden Highside- und Lowside-Schalter 20, 24 werden mittels einer Steuereinheit 32 angesteuert, die wiederum von extern Signale empfängt, um den Unterbrechungs-Halbleiterschalter im Bedarfsfall und damit zielgerichtet in den AUSZustand zu überführen.

Es sei angenommen, dass in der Versorgungsleitung 34, die zu dem bei 36 angedeuteten elektrischen Verbraucher führt, ein Störimpuls entsteht, was beispielsweise durch EMV-Einkopplung, durch einen automotiven Störpuls gemäß ISO7637 oder auch durch einen Puls in Folge eines Schaltvorganges des Halbleiterschalters 12 der gezeigten Struktur oder eines Halbleiterschalters in einer parallel angeordneten, vergleichbar aufgebauten Schaltungsanordnung (gemäß Fig.1) erfolgen kann. Wegen der parasitären kapazitiven Kopplung der Ansteuerelektrode 14 des Unterbrechungs-Halbleiterschalters 12 zu den anderen Anschlüssen dieses Halbleiterschalters gelangen also die Störpulse bzw. das Störsignal zur Ansteuerleitung 38 zwischen der Ansteuerelektrode 14 und dem Ausgangsanschluss 28 des Treibers 16. Vom Ausgangsanschluss 28 aus betrachtet weist der Treiber 16 einen unsymmetrischen Aufbau auf, da nämlich der Highside-Schalter 20 ein PMOS-Transistor 18 und der Lowside-Schalter 24 ein NMOS-Transistor 22 ist. Statt eines NMOS-Transistors 22 kann der Treiber 16 auch eine anders gestaltete Einheit 40 (z. B. einen Widerstand oder eine Stromquelle) aufweisen, die zum Zweck der beabsichtigten Abschaltung des Unterbrechungs-Halbleiterschalters 12 von dessen Ansteuerelektrode 14 elektrische Ladung nach Masse 42 abfließen lässt. Von den zwei zwischen der n-Wanne des PMOS-Transistors 18 und dessen Source S einerseits sowie dessen Drain D andererseits vorhandenen parasitären Dioden (in Fig. 1 und den anderen Figuren gestrichelt angedeutet) erlaubt die insoweit elektrisch wirksame parasitäre Diode D₁ zwischen Drain D und der n-Wanne des PMOS-Transistors 18 nun einen Rückwärtsstrom durch den PMOS-Transistor 18, was zu einer Mittenpotentialverschiebung am Ausgangsanschluss 28 des Treibers 16 führt (siehe die Veränderung Störsignalverläufe A und B). Das hat zur Folge, dass sich der Unterbrechungs-Halbleiterschalter 12 ungewollt in seiner Funktion beeinträchtigt oder sogar ausschaltet wird.

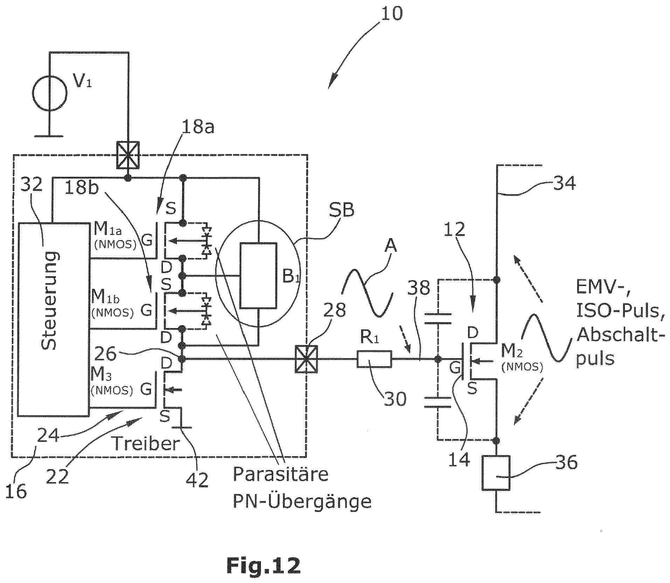

Ganz generell sei zur Beschaltung gemäß Fig. 1 und auch zu den im Folgenden beschriebenen erfindungsgemäßen Beschaltungen des Unterbrechungs-Halbleiterschalters 12 gesagt, dass dieser auch als PMOS-Transistor ausgeführt sein kann. In den Figuren ist der Unterbrechungs-Halbleiterschalter demgegenüber stets als NMOS-Transistor dargestellt. Auch kann der Aufbau des Treibers 16 statt der dort gezeigten PMOS- und NMOS-Transistoren auch Transistoren vom gleichen Typ aufweisen, insbesondere statt des PMOS-Transistors in Reihe geschaltete NMOS-Transistoren, die in getrennten n-Wannen oder in einer gemeinsamen n-Wanne ausgebildet sind, wobei jede oder die n-Wanne somit den NMOS-Transistor gegenüber dem p-dotierten Halbleitersubstrat isoliert (siehe Fig. 12).

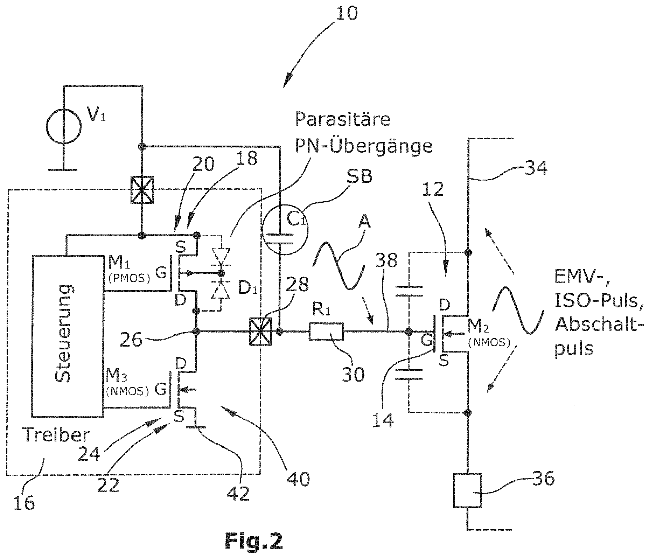

Anhand der Fign. 2 bis 14 werden nachfolgend verschiedene Beschaltungen (Störunterdrückungs-Bauteilanordnungen SB) des Treibers 16 beschrieben bzw. gezeigt, mit denen es gelingt, ein ungewolltes Abschalten des Unterbrechungs-Halbleiterschalters 12 in Folge der Beeinflussung des Treibers 16 durch in die Ansteuerleitung 38 eingekoppelte Störpulse zu reduzieren oder zu verhindern. Der Widerstand R₁ ist in Fig. 1 und sämtlichen im Folgenden beschriebenen Ausführungsbeispielen der Erfindung optional und begrenzt den Rückstromfluss in der Ansteuerleitung 38, wenn in diese ein Störsignal eingekoppelt wird. Der Widerstand 30 kann alternativ auch im Treiber 16 angeordnet sein (z. B. aufgeteilt beidseitig des Verbindungsknotens 16 oder zwischen diesem und dem Ausgangsanschluss 28. Diese Alternativen gelten grundsätzlich für sämtliche hier gezeigten und beschriebenen Varianten der Erfindung.

Gemäß Fig. 2 wird zwischen die Versorgungspannung V₁ und den Ausgangsanschluss 28 des Treibers 16 eine Kapazität C₁ geschaltet, die zu einer Verringerung der Amplitude des potentiell in die Ansteuerleitung 38 eingekoppelten Störpulses (siehe in Fig. 2 bei B) führt. Damit schaltet die parasitäre Diode D₁ nicht mehr, so dass sich keinerlei Mittenpotentialverschiebungen auf der Ansteuerleitung 38 ergeben und somit der Unterbrechungs-Halbleiterschalter 12 unverändert im EIN-Zustand verbleibt. Die Kapazität C₁ wirkt also wie ein Filter und senkt auf diese Weise den sich auf den Treiber 16 auswirkenden Störpegel bis unterhalb der Diodenspannung der parasitären Diode D₁ ab. Es kommt also zu keinerlei gleichrichtender Wirkung des Störsignals auf der Ansteuerleitung 38.

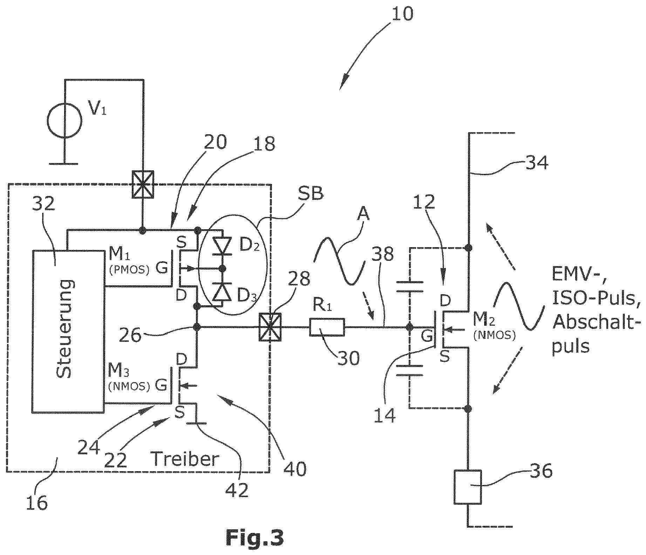

In Fig. 3 ist gezeigt, wie die n-Wanne des PMOS-Transistors 18 (Highside-Schalter des Treibers 16) durch zwei antiparallel geschaltete Dioden D₂ und D₃, deren Kathoden miteinander sowie mit der n-Wanne verbunden sind, dergestalt angebunden werden kann, dass am Treiberausgangsanschluss 28 nun ein erhöhter Spannungsanstieg erlaubt ist, ohne dass dies Auswirkungen auf ein inverses Durchschalten des PMOS-Transistors hat. Optional ist es in dieser wie auch allen folgenden Figuren möglich, dass die Steuereinheit 32 für den PMOS-Transistors 18 an dessen n-Wanne angeschlossen ist bzw. diese betreibt oder von dieser versorgt wird. Diese Anordnung stellt vorteilhafterweise eine implizite Entladung zum Schutz gegen Aufladung der Wanne des PMOS-Transistors 18 bereit. Darüber hinaus dient diese optionale Anordnung der Vermeidung einer Potentialverschiebung zwischen der Steuereinheit 32 und dem Ansteuerknoten des PMOS-Transistor 18.

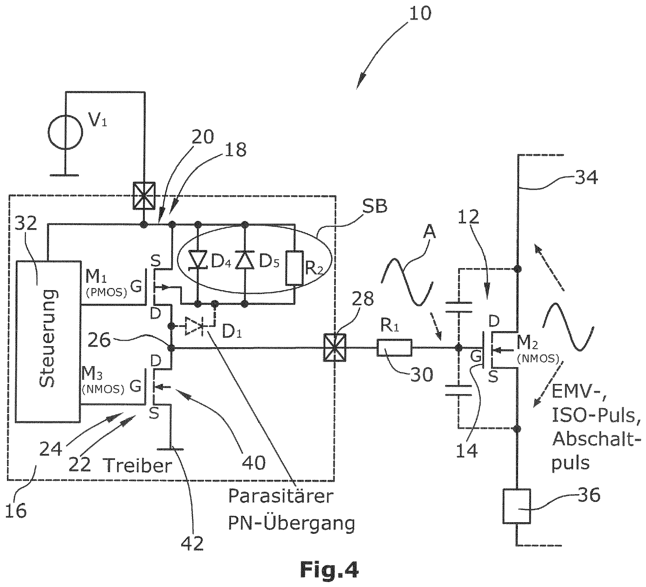

In Fig. 4 ist die Alternative dargestellt, dass eine in diesem Ausführungsbeispiel Schottky-Diode D₄ eine Rückspeisung zwischen dem Ausgangsanschluss 28 und dem Versorgungspotential verhindert. Die Kathode der Schottky-Diode D₄ ist mit der n-Wanne des PMOS-Transistors 18 verbunden, während ihre Anode mit Source S verbunden ist. Der Spannungshub an der n-Wanne des PMOS-Transistors 18 kann zur Vermeidung von Aufladungseffekten bei z. B. funktionsgemäßem Betrieb durch eine optional vorzusehende antiparallel zu D₄ geschaltete Diode D₅ begrenzt werden. Statt als Schottky-Diode kann D₄ auch als Zener-Diode ausgeführt sein. Ferner kann durch den Widerstand R₂ für einen DC-Potentialausgleich mit der Versorgungspannung V₁ gesorgt werden. Der Widerstand R₂ wirkt dabei statisch zur Entladung der n-Wanne des PMOS-Transistors 18 und sollte so dimensioniert sein, dass er dynamisch, im Wesentlichen keine negativen Auswirkungen auf die Ableitung von Störimpulsen hat. Zur insoweit zu beachtenden Dimensionierung des Widerstandes siehe die Ausführungen oben.

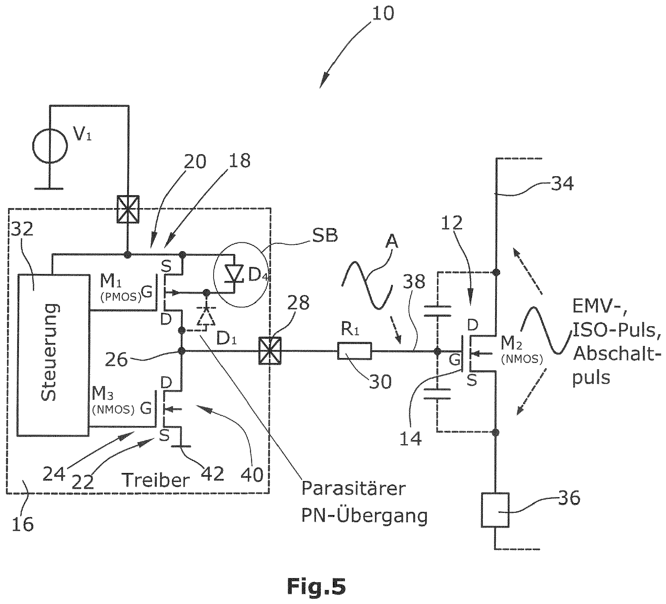

In Fig. 5 ist gezeigt, dass die Diode D₄ gemäß dem Ausführungsbeispiel nach Fig. 4 als Zenerdiode ausgeführt sein kann, die eine Funktion vergleichbar derjenigen der antiparallel geschalteten Dioden D₄ und D₅ des Ausführungsbeispiels nach Fig. 4 realisiert.

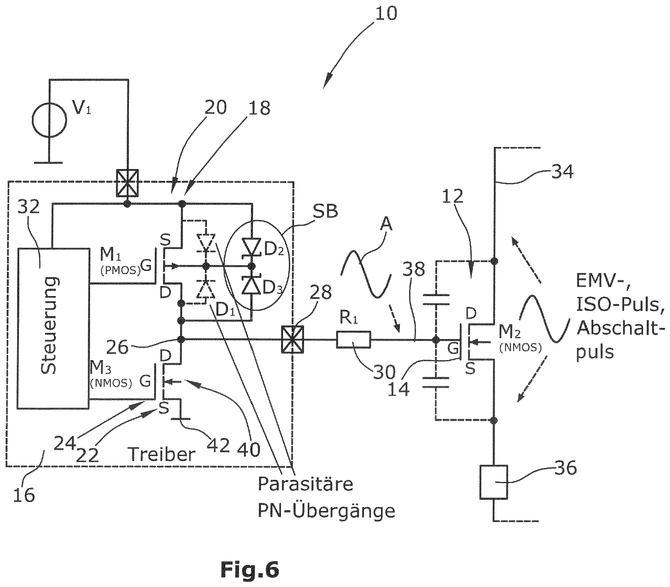

In Fig. 6 ist eine Alternative gezeigt, bei der die beiden Dioden D₂ und D₃ gemäß Verschaltung wie in Fig. 3 als Schottky-Dioden ausgeführt sind.

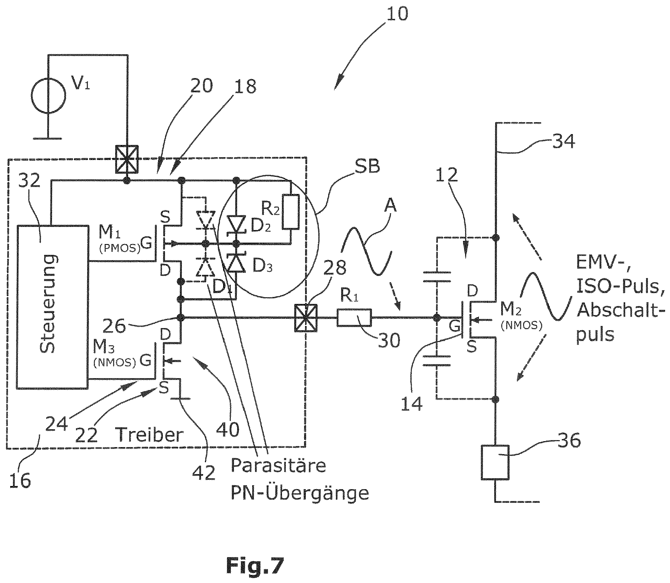

In Fig. 7 ist zusätzlich zu den Schottky-Dioden D₂ und D₃ noch ein Widerstand R₂ vorgesehen, der einen DC-Entladungswiderstand gegen die Versorgung zur Vermeidung von Aufladungseffekten (Stichwort: Charge-Pumping) darstellt. Die Aufladung der n-Wanne des PMOS-Transistors 18 könnte ungewollte Schwellspannungserhöhungen und in der Folge eine reduzierte Performance des PMOS-Transistors 18 zur Folge haben, was bis hin zur mangelnden Schaltfähigkeit dieses Transistors führen kann. Dies wird durch den DC-Entladungswiderstand R₂ verhindert.

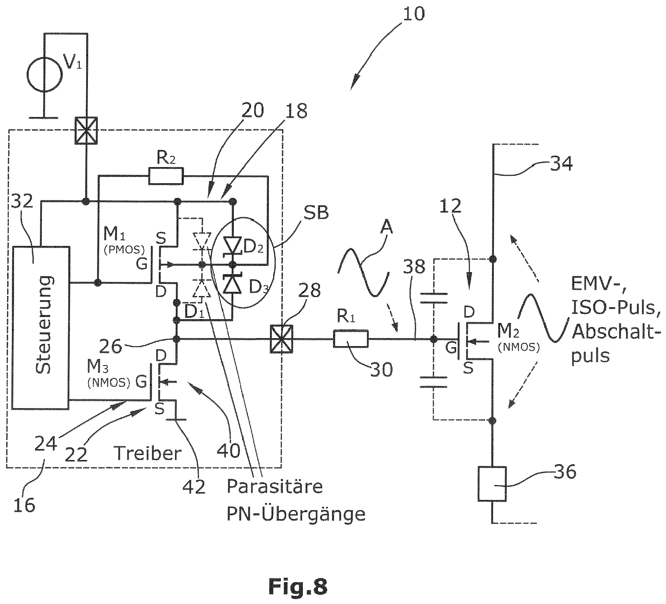

Fig. 8 zeigt den Fall, dass der Entladungswiderstand R₂ zwischen der n-Wanne des PMOS-Transistors 18 und dessen Gate G geschaltet ist.

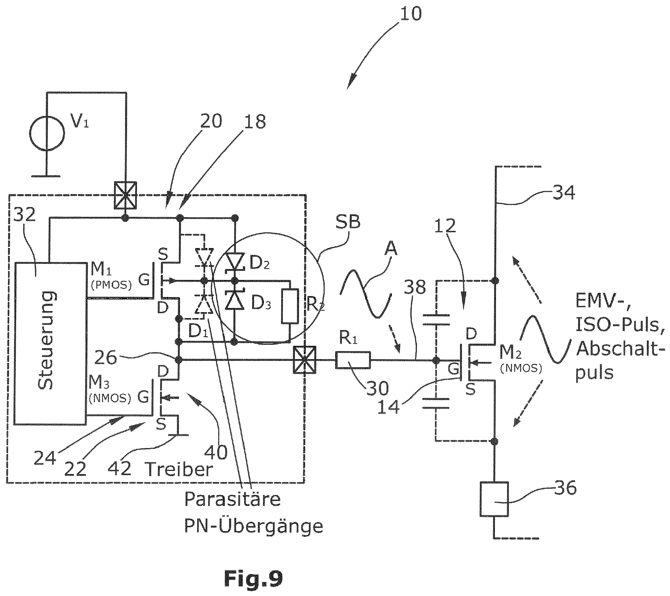

Fig. 9 schließlich zeigt den Fall, bei dem der DC-Entladungswiderstand R₂ parallel zur Schottky-Diode D₃ geschaltet ist. Dies sorgt in vorteilhafter Weise für einen "umgekehrten" Substrat- bzw. Bodyeffekt am PMOS-Transistor 18, der die Schwellspannung und damit den R_{DSON} des PMOS-Transistors 18 absenkt. Somit wirkt sich also eine Spannungserhöhung am Ausgangsanschluss 28 des Treibers 16 nicht negativ auf dessen Funktionsweise aus, wenn auf der Ansteuerleitung 38 Störimpulse eingekoppelt werden.

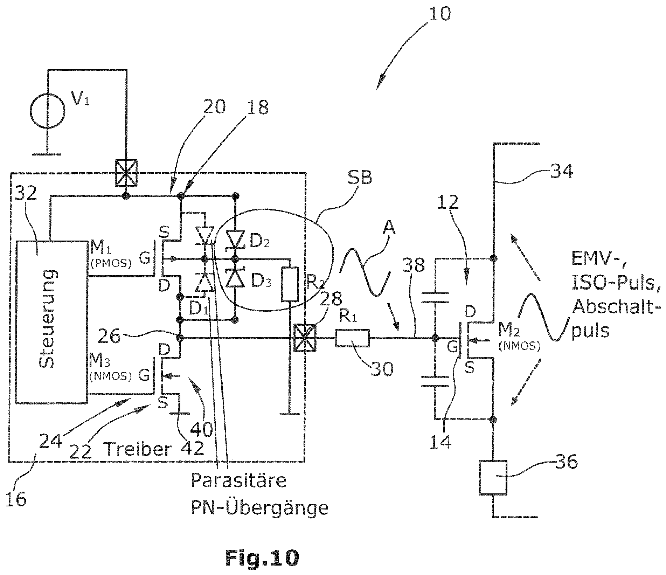

In Fig. 10 ist der Fall gezeigt, dass der Entladungswiderstand R₂ zwischen die n-Wanne des PMOS-Transistors 18 und Masse geschaltet ist.

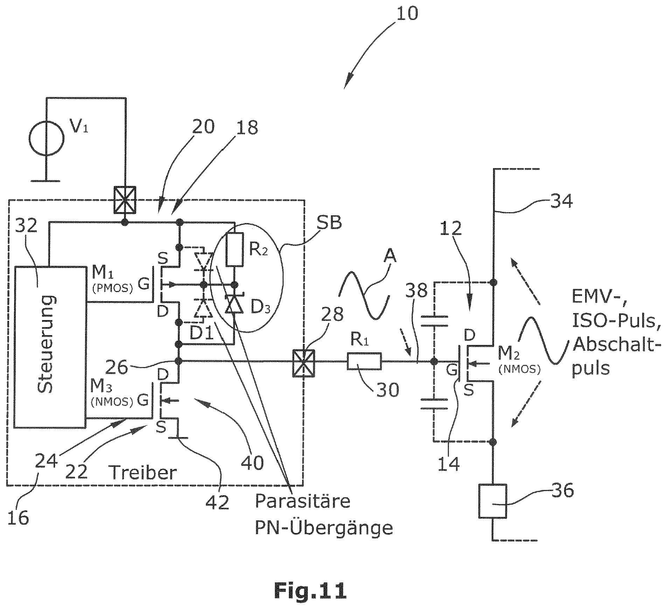

Anhand des Ausführungsbeispiels gemäß Fig. 11 ist eine vereinfachte Wannenanbindung des PMOS-Transistors 18 über den DC-Entladungswiderstand R₂ zu erkennen. Dies führt zu einem minimalen Integrationsaufwand. Die Diode D₃ ist lediglich optional vorhanden, da die Wannenaufladung auch alternativ durch die parasitäre Diode zwischen Drain und der n-Wanne des PMOS-Transistors 18 erfolgen kann.

In Fig. 12 ist ein alternativer Schalteraufbau zum PMOS-Transistor 18 der vorherigen Ausführungsbeispiele gezeigt. Der PMOS-Transistor 18 ist ersetzt durch zwei in Reihe geschaltete NMOS-Transistoren 18a, 18b, die jeweils mit parasitären Dioden versehen sind. Mit B₁ ist ein "Platzhalter" bezeichnet, der alternativ eine der Anordnungen zur Speisung des Wannenpotentials der beiden NMOS-Transistoren 18a und 18b gemäß den vorherigen Ausführungsbeispielen repräsentieren soll.

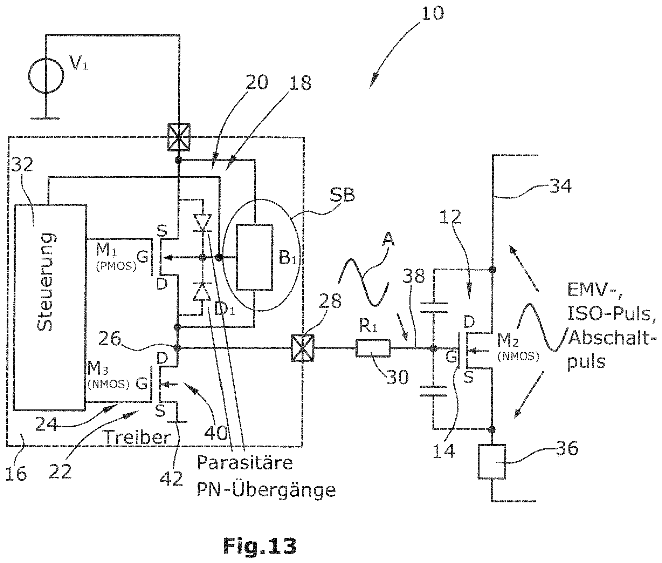

Anhand der Fig. 13 ist gezeigt, dass die Steuereinheit 32 das an der n-Wanne des PMOS-Transistors 18 befindliche Potential zur Versorgung verwendet. Das hat den Vorteil, dass die Gate-Ansteuerung des PMOS-Transistors 18 auf einem Potential erfolgt, das die Steuerung des PMOS-Transistors 18 erlaubt, und zwar unabhängig von dem Maß des Potentials an der n-Wanne, d. h. unabhängig vom Maß der Wannenaufladung. Wiederum ist mit B₁ ein Platzhalter bezeichnet, der wahlweise eine der zuvor genannten Alternativen für die Wannenaufhängung repräsentiert. Die n-Wanne des PMOS-Transistors 18 ist dabei über einen (nicht gezeigten) ohmschen Widerstand mit dem Gate-Anschluss G des PMOS-Transistors 18 gekoppelt (d. h. elektrisch direkt oder indirekt verbunden).

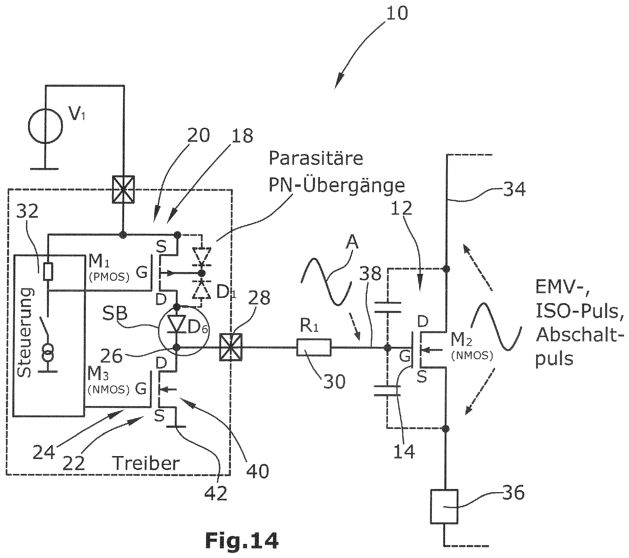

Schließlich zeigt Fig. 14 ein Ausführungsbeispiel, bei dem zwischen den Verbindungsknoten 26 und Drain D des PMOS-Transistors 18 eine Diode D₆ geschaltet ist, die verhindert, dass der PMOS-Transistor 18 hinsichtlich seiner vorgeschriebenen Funktionsweise beeinträchtigt ist, wenn in die Ansteuerleitung 38 Störsignale eingekoppelt werden.

Die Erfindung lässt sich ferner alternativ durch eine der nachfolgend genannten Merkmalsgruppen umschreiben, wobei die Merkmalsgruppen beliebig miteinander kombinierbar sind und auch einzelne Merkmale einer Merkmalsgruppe mit ein oder mehreren Merkmalen einer oder mehrerer anderer Merkmalsgruppen und/oder einer oder mehrerer der zuvor beschriebenen Ausgestaltungen kombinierbar sind.
1. Vorrichtung zur Ansteuerung einer elektronischen Sicherung für mindestens einen elektrischen Verbraucher insbesondere eines Fahrzeugs, mit
   - mindestens einem Unterbrechungs-Halbleiterschalter 12 zur Unterbrechung der Zufuhr elektrischer Energie über eine Versorgungsleitung 34 zu einem Verbraucher 36 im Falle einer Störung des Verbrauchers 36, wobei der Unterbrechungs-Halbleiterschalter 12 eine Ansteuerelektrode 14 aufweist,
   - einem Treiber 16 für den Unterbrechungs-Halbleiterschalter 12, wobei der Treiber 16 einen elektrisch mit der Ansteuerelektrode 14 des Unterbrechungs-Halbleiterschalters 12 verbundenen Ausgangsanschluss 28 zur Lieferung einer DC-Ansteuerspannung für den Unterbrechungs-Halbleiterschalter 12 über eine zu dessen Ansteuerelektrode 14 führenden Ansteuerleitung 38 aufweist,
   - wobei der Treiber 16 ferner versehen ist mit einem Highside-Schalter 20, der zwischen einem Versorgungspotential V₁ und dem Ausgangsanschluss 28 geschaltet ist, und mit einer zwischen dem Ausgangsanschluss 28 und Masse 42 geschalteten elektrischen und/oder elektronischen Einheit 40 zur zwecks Öffnen des Unterbrechungs-Halbleiterschalters 12 erfolgenden Ableitung eines Stroms von der Ansteuerelektrode 14 des Unterbrechungs-Halbleiterschalters 12, und
   - mindestens einer elektrischen und/oder elektronischen Störunterdrückungs-Bauteilanordnung SB zur Verhinderung einer den Betrieb des Unterbrechungs-Halbleiterschalters 12 beeinträchtigenden und insbesondere ein ungewolltes Öffnen des Unterbrechungs-Halbleiterschalters 12 verursachenden Potentialveränderung, insbesondere Mittelwertverschiebung, am Ausgangsanschluss 28 des Treibers 16 als Folge von unsymmetrischen Reaktionen des Treibers 16 auf Störsignale, die über die Versorgungsleitung 34 des Verbrauchers einkoppelbar sind und/oder in der Versorgungsleitung 34 des Verbrauchers entstehen.
2. Vorrichtung nach Ziffer 1, wobei die Störunterdrückungs-Bauteilanordnung SB eine Kapazität C₁ zur Reduktion der Größe des Störsignals aufweist, die insbesondere als Kondensator ausgebildet ist, wobei die Kapazität C₁ zwischen einerseits die zur Ansteuerelektrode 14 des Unterbrechungs-Halbleiterschalters 12 führenden Ansteuerleitung 38 und andererseits entweder die Versorgungsspannung V₁ oder die Masse 42 geschaltet ist.
3. Vorrichtung nach Ziffer 1, wobei der Highside-Schalter 20 ein PMOS-Transistor 18 ist, der eine in einem Halbleitersubstrat ausgebildete n-dotierte n-Wanne mit einem Drain-Anschlussgebiet D und einem Source-Anschlussgebiet S aufweist und der mit einer Gate-Elektrode G versehen ist, und wobei die Störunterdrückungs-Bauteilanordnung SB zur Erhöhung der Toleranz gegenüber Störsignalen, d. h. zur Erhöhung der Schaltschwelle bei am Ausgangsanschluss 28 des Treibers 16 anliegenden Störsignalen, zwei Dioden D₂ und D₃ aufweist, die hinsichtlich ihrer Sperrrichtungen gegensinnig in Reihe geschaltet sind, wobei ihre Kathoden elektrisch miteinander sowie mit der n-Wanne des PMOS-Transistors 18 verbunden sind.
4. Vorrichtung nach Ziffer 3, wobei mindestens eine der beiden Dioden D₂ und D₃ als parasitäre Diode zwischen einerseits dem Drain-Anschlussgebiet D oder dem Source-Anschlussgebiet S des PMOS-Transistors 18 und andererseits dessen n-Wanne ausgebildet ist.
5. Vorrichtung nach Ziffer 3, wobei mindestens eine der beiden Dioden D₂ und D₃ als Schottky-Dioden ausgeführt ist.
6. Vorrichtung nach Ziffer 3 oder 4, wobei parallel zu einer der beiden Dioden D₂ und D₃ zwischen der n-Wanne des PMOS-Transistors 18 und dessen Drain D bzw. zwischen der n-Wanne des PMOS-Transistors 18 und dem Versorgungspotential V₁ ein ohmscher Widerstand R₂ zur Vermeidung von Aufladungen der n-Wanne des PMOS-Transistors 18 geschaltet ist.
7. Vorrichtung nach Ziffer 4 oder 5, wobei parallel zu einer der beiden Dioden D₂ und D3 zwischen der n-Wanne des PMOS-Transistors 18 und Masse 42 ein ohmscher Widerstand R₂ zur Vermeidung von Aufladungen der n-Wanne geschaltet ist.
8. Vorrichtung nach Ziffer 1, wobei der Highside-Schalter 20 ein PMOS-Transistor 18 ist, der eine in einem Halbleitersubstrat ausgebildete n-dotierte n-Wanne mit einem Drain-Anschlussgebiet D und einem Source-Anschlussgebiet S aufweist und der mit einer Gate-Elektrode G versehen ist, und wobei die Störunterdrückungs-Bauteilanordnung SB zur Erhöhung der Toleranz gegenüber Störsignalen, d. h. zur Erhöhung der Schaltschwelle bei am Ausgangsanschluss 28 des Treibers 16 anliegenden Störsignalen, eine erste Diode D₄, insbesondere eine Schottky-Diode aufweist, deren Kathode mit der n-Wanne und deren Anode mit dem Source-Anschlussgebiet S des PMOS-Transistors 18 verbunden ist.
9. Vorrichtung nach Ziffer 8, wobei zur Begrenzung von Spannungshüben in der n-Wanne des PMOS-Transistors 18 zwischen dieser und dem Source-Anschlussgebiet S des PMOS-Transistors 18 eine antiparallel zur ersten Diode D₄ angeordnete weitere Diode D₅ geschaltet ist.
10. Vorrichtung nach Ziffer 8 oder 9, wobei zum DC-Potentialausgleich der Versorgungsspannung V₁ parallel zur ersten Diode D₄ ein Widerstand R₂ geschaltet ist.
11. Vorrichtung nach Ziffer 1, wobei der Highside-Schalter 20 ein PMOS-Transistor 18 ist, der eine in einem Halbleitersubstrat ausgebildete n-dotierte n-Wanne mit einem Drain-Anschlussgebiet D und einem Source-Anschlussgebiet S aufweist und der mit einer Gate-Elektrode G versehen ist, und wobei die Störunterdrückungs-Bauteilanordnung SB zur Erhöhung der Toleranz gegenüber Störsignalen, d. h. zur Erhöhung der Schaltschwelle bei am Ausgangsanschluss 28 des Treibers 16 anliegenden Störsignalen, eine Zener-Diode D₄ aufweist, deren Kathode mit der n-Wanne und deren Anode mit dem Source-Anschlussgebiet S des PMOS-Transistors 18 verbunden ist.
12. Vorrichtung nach einer der Ziffern 8 bis 11, wobei zwischen einerseits der n-Wanne des PMOS-Transistors 18 und andererseits einem seiner Anschlüsse S, D oder dem Versorgungspotential V₁ oder der Masse 42 zur Vermeidung von Aufladungen der n-Wanne ein ohmscher Widerstand geschaltet ist.
13. Vorrichtung nach Ziffer 12, wobei zwischen dem Ausgangsanschluss 28 des Treibers 16 und der n-Wanne des PMOS-Transistors 18 eine Diode D₃, insbesondere eine Schottky-Diode geschaltet ist, deren Kathode mit der n-Wanne des PMOS-Transistors verbunden ist.
14. Vorrichtung nach Ziffer 1, wobei der Highside-Schalter 20 in Form zweier voneinander isolierter NMOS-Transistoren 18a, 18b mit jeweils einer parasitären und/oder separat vorgesehenen Diode zwischen dem Drain-Anschlussgebiet D und dem Source-Anschlussgebiet S jedes NMOS-Transistors 18a, 18b ausgebildet ist, wobei die Drain-Source-Strecke der beiden NMOS-Transistoren 18a, 18b in Reihe miteinander geschaltet sind, wobei entweder die Drain-Anschlussgebiete D oder die Source-Anschlussgebiete S der beiden NMOS-Transistoren 18a, 18b unter Bildung eines Verbindungspunkts miteinander verbunden sind und wobei die beiden parasitären Dioden und/oder die beiden separat vorgesehenen Dioden jeweils hinsichtlich ihrer Sperrrichtung gegensinnig sind und insbesondere ihre Kathoden miteinander sowie mit dem Verbindungspunkt der beiden NMOS-Transistoren 18a, 18b verbunden sind.
15. Vorrichtung nach Ziffer 14, wobei
   - die beiden separaten Dioden als Schottky-Dioden ausgebildet sind, oder
   - die beiden separaten Dioden als Schottky-Dioden ausgebildet sind und zur Vermeidung von Aufladungen der p-dotierten p-Wannen der NMOS-Transistoren 18a, 18b parallel zu mindestens einer der parasitären und/oder separaten Diode ein ohmscher Widerstand R₂ nach Versorgungspotential V₁ oder Masse 42 geschaltet ist.
16. Vorrichtung nach Ziffer 1, wobei in Reihe mit dem Highside-Schalter 20 des Treibers 16 mindestens eine Diode D₆ geschaltet ist, deren Kathode den Ausgangsanschluss 28 des Treibers 16 bildet, wobei die mindestens eine Diode D₆ einen aus Störsignalen potentiell resultierenden Stromfluss von der Ansteuerelektrode 14 des Unterbrechungs-Halbleiterschalters 12 zum Highside-Schalter 20 und damit eine den Betrieb des Unterbrechungs-Halbleiterschalters 12 beeinträchtigende und insbesondere ein ungewolltes Öffnen des Unterbrechungs-Halbeiterschalters 12 verursachende Potentialverschiebung, insbesondere Mittelwertverschiebung, am Ausgangsanschluss 28 des Treibers 16 verhindert bzw. limitiert.
17. Vorrichtung nach einer der Ziffern 1 bis 16, wobei in der vom Ausgangsanschluss 28 des Treibers 16 verlaufenden Ansteuerleitung 38 zwischen der Störunterdrückungs-Bauteilanordnung SB und der Ansteuerelektrode 14 des Unterbrechungs-Halbleiterschalters 12 ein ohmscher Widerstand R₁ angeordnet ist.
18. Vorrichtung nach einer der Ziffern 3, 8 oder 11 oder einer der vorhergehenden Ziffern, sofern diese auf Ziffer 3, 8 oder 11 rückbezogen ist, wobei das Potential der n-Wanne des PMOS-Transistors 18 der Versorgung der Steuereinheit 32 dient.

Die Erfindung lässt sich ferner alternativ gemäß einem oder mehreren der nachfolgend aufgeführten Merkmale bzw. Merkmalsgruppen definieren:
1. Elektronische Sicherung für mindestens einen elektrischen Verbraucher insbesondere eines Fahrzeugs, mit
   - mindestens einem Unterbrechungs-Halbleiterschalter (12) zur Unterbrechung der Zufuhr elektrischer Energie über eine Versorgungsleitung (34) zu einem Verbraucher (36) im Falle einer Störung des Verbrauchers (36), wobei der Unterbrechungs-Halbleiterschalter (12) eine Ansteuerelektrode (14) aufweist, und
   - einer Vorrichtung zur Ansteuerung des Unterbrechungs-Halbleiterschalters (12), die versehen ist mit
      - einem Treiber (16) für den Unterbrechungs-Halbleiterschalter (12), wobei der Treiber (16) einen elektrisch mit der Ansteuerelektrode (14) des Unterbrechungs-Halbleiterschalters (12) verbundenen Ausgangsanschluss (28) zur Lieferung einer DC-Ansteuerspannung für den Unterbrechungs-Halbleiterschalter (12) über eine zu dessen Ansteuerelektrode (14) führende Ansteuerleitung (38) aufweist,
      - wobei der Treiber (16) ferner versehen ist mit einem Highside-Schalter (20), der zwischen einem Versorgungspotential (V₁) und dem Ausgangsanschluss (28) geschaltet ist, und mit einer zwischen dem Ausgangsanschluss (28) und Masse (42) geschalteten elektrischen und/oder elektronischen Einheit (40) zur zwecks Öffnens des Unterbrechungs-Halbleiterschalters (12) erfolgenden Ableitung eines Stroms von der Ansteuerelektrode (14) des Unterbrechungs-Halbleiterschalters (12), und
      - mindestens einer elektrischen und/oder elektronischen Störunterdrückungs-Bauteilanordnung (SB) zur Verhinderung einer den Betrieb des Unterbrechungs-Halbleiterschalters (12) beeinträchtigenden und insbesondere ein ungewolltes Öffnen des Unterbrechungs-Halbleiterschalters (12) verursachenden Potentialveränderung, insbesondere Mittelwertverschiebung, am Ausgangsanschluss (28) des Treibers (16) als Folge von unsymmetrischen Reaktionen des Treibers (16) auf Störsignale, die über die Versorgungsleitung (34) des Verbrauchers einkoppelbar sind und/oder in der Versorgungsleitung (34) des Verbrauchers entstehen.
2. Elektronische Sicherung nach Ziffer 1, dadurch gekennzeichnet, dass die Störunterdrückungs-Bauteilanordnung (SB) eine Kapazität (C₁) zur Reduktion der Größe des Störsignals aufweist, die insbesondere als Kondensator ausgebildet ist, wobei die Kapazität (C₁) zwischen einerseits die zur Ansteuerelektrode (14) des Unterbrechungs-Halbleiterschalters (12) führenden Ansteuerleitung (38) und andererseits entweder die Versorgungsspannung (V₁) oder die Masse (42) geschaltet ist.
3. Elektronische Sicherung nach Ziffer 1 oder 2, dadurch gekennzeichnet, dass der Highside-Schalter (20) ein PMOS-Transistor (18) ist, der eine in einem Halbleitersubstrat ausgebildete n-dotierte n-Wanne mit einem Drain-Anschlussgebiet (D) und einem Source-Anschlussgebiet (S) aufweist und der mit einer Gate-Elektrode (G) versehen ist, und dass die Störunterdrückungs-Bauteilanordnung (SB) zur Erhöhung der Toleranz gegenüber Störsignalen, d.h. zur Erhöhung der Schaltschwelle bei am Ausgangsanschluss (28) des Treibers (16) anliegenden Störsignalen, zwei ggf. zusätzlich zum PMOS-Transistor (18) vorgesehene Dioden (D₂ und D₃) aufweist, die hinsichtlich ihrer Sperrrichtungen gegensinnig in Reihe geschaltet sind, wobei ihre Kathoden elektrisch miteinander sowie mit der n-Wanne des PMOS-Transistors (18) verbunden sind.
4. Elektronische Sicherung nach Ziffer 3, dadurch gekennzeichnet, dass mindestens eine der beiden Dioden (D₂, D₃) als parasitäre Diode zwischen einerseits dem Drain-Anschlussgebiet (D) oder dem Source-Anschlussgebiet (S) des PMOS-Transistors (18) und andererseits dessen n-Wanne ausgebildet ist.
5. Elektronische Sicherung nach Ziffer 3, dadurch gekennzeichnet, dass mindestens eine der beiden Dioden (D₂, D₃) als Schottky-Dioden ausgeführt ist.
6. Elektronische Sicherung nach Ziffer 3 oder 4, dadurch gekennzeichnet, dass parallel zu einer der beiden Dioden (D₂, D₃) zwischen der n-Wanne des PMOS-Transistors (18) und dessen Drain-Anschlussgebiet (D) bzw. zwischen der n-Wanne des PMOS-Transistors (18) und dem Versorgungspotential (V₁) ein ohmscher Widerstand (R₂) zur Vermeidung von Aufladungen der n-Wanne des PMOS-Transistors (18) geschaltet ist.
7. Elektronische Sicherung nach Ziffer 4 oder 5, dadurch gekennzeichnet, dass parallel zu einer der beiden Dioden (D₂, D3) zwischen der n-Wanne des PMOS-Transistors (18) und Masse (42) ein ohmscher Widerstand (R₂) zur Vermeidung von Aufladungen der n-Wanne geschaltet ist.
8. Elektronische Sicherung nach Ziffer 1, dadurch gekennzeichnet, dass der Highside-Schalter (20) ein PMOS-Transistor (18) ist, der eine in einem Halbleitersubstrat ausgebildete n-dotierte n-Wanne mit einem Drain-Anschlussgebiet (D) und einem Source-Anschlussgebiet (S) aufweist und der mit einer Gate-Elektrode (G) versehen ist, und dass die Störunterdrückungs-Bauteilanordnung (SB) zur Erhöhung der Toleranz gegenüber Störsignalen, d.h. zur Erhöhung der Schaltschwelle bei am Ausgangsanschluss (28) des Treibers (16) anliegenden Störsignalen, eine erste Diode (D₄), insbesondere eine Schottky-Diode aufweist, deren Kathode mit der n-Wanne und deren Anode mit dem Source-Anschlussgebiet (S) des PMOS-Transistors (18) verbunden ist.
9. Elektronische Sicherung nach Ziffer 8, dadurch gekennzeichnet, dass zur Begrenzung von Spannungshüben in der n-Wanne des PMOS-Transistors (18) zwischen dieser und dem Source-Anschlussgebiet (S) des PMOS-Transistors (18) eine antiparallel zur ersten Diode (D₄) angeordnete weitere Diode (D₅) geschaltet ist.
10. Elektronische Sicherung nach Ziffer 8 oder 9, dadurch gekennzeichnet, dass zum DC-Potentialausgleich der Versorgungsspannung V₁ parallel zur ersten Diode (D₄) ein Widerstand (R₂) geschaltet ist.
11. Elektronische Sicherung nach Ziffer 1, dadurch gekennzeichnet, dass der Highside-Schalter (20) ein PMOS-Transistor (18) ist, der eine in einem Halbleitersubstrat ausgebildete n-dotierte n-Wanne mit einem Drain-Anschlussgebiet (D) und einem Source-Anschlussgebiet (S) aufweist und der mit einer Gate-Elektrode (G) versehen ist, und dass die Störunterdrückungs-Bauteilanordnung (SB) zur Erhöhung der Toleranz gegenüber Störsignalen, d.h. zur Erhöhung der Schaltschwelle bei am Ausgangsanschluss (28) des Treibers (16) anliegenden Störsignalen, eine Zener-Diode (D₄) aufweist, deren Kathode mit der n-Wanne und deren Anode mit dem Source-Anschlussgebiet (S) des PMOS-Transistors (18) verbunden ist.
12. Elektronische Sicherung nach einer der Ziffern 8 bis 11, dadurch gekennzeichnet, dass zwischen einerseits der n-Wanne des PMOS-Transistors (18) und andererseits einem seiner Anschlüsse (S, D) oder dem Versorgungspotential (V₁) oder der Masse (42) zur Vermeidung von Aufladungen der n-Wanne ein ohmscher Widerstand geschaltet ist.
13. Elektronische Sicherung nach Ziffer 12, dadurch gekennzeichnet, dass zwischen dem Ausgangsanschluss (28) des Treibers (16) und der n-Wanne des PMOS-Transistors (18) eine Diode (D₃), insbesondere eine Schottky-Diode geschaltet ist, deren Kathode mit der n-Wanne des PMOS-Transistors (18) verbunden ist.
14. Elektronische Sicherung nach Ziffer 1, dadurch gekennzeichnet, dass der Highside-Schalter (20) in Form zweier in einem Halbleitersubstrat gegenüber diesem isoliert ausgebildeter NMOS-Transistoren (18a, 18b) mit jeweils einer parasitären und/oder separat vorgesehenen Diode zwischen dem Drain-Anschlussgebiet (D) und dem Source-Anschlussgebiet (S) jedes NMOS-Transistors (18a, 18b) ausgebildet ist, dass die Drain-Source-Strecke der beiden NMOS-Transistoren (18a, 18b) in Reihe miteinander geschaltet sind, wobei entweder die Drain-Anschlussgebiete (D) oder die Source-Anschlussgebiete (S) der beiden NMOS-Transistoren (18a, 18b) unter Bildung eines Verbindungspunkts miteinander verbunden sind und wobei die beiden parasitären Dioden und/oder die beiden separat vorgesehenen Dioden jeweils hinsichtlich ihrer Sperrrichtung gegensinnig sind und insbesondere ihre Kathoden miteinander sowie mit dem Verbindungspunkt der beiden NMOS-Transistoren (18a, 18b) verbunden sind.
15. Elektronische Sicherung nach Ziffer 14, dadurch gekennzeichnet,
   - dass die beiden separaten Dioden als Schottky-Dioden ausgebildet sind, oder
   - dass die beiden separaten Dioden als Schottky-Dioden ausgebildet sind und zur Vermeidung von Aufladungen der p-dotierten p-Wannen der NMOS-Transistoren (18a, 18b) parallel zu mindestens einer der parasitären und/oder separaten Diode ein ohmscher Widerstand (R₂) nach Versorgungspotential (V₁) oder Masse (42) geschaltet ist.
16. Elektronische Sicherung nach Ziffer 1, dadurch gekennzeichnet, dass in Reihe mit dem Highside-Schalter (20) des Treibers (16) mindestens eine Diode (D₆) geschaltet ist, deren Kathode den Ausgangsanschluss (28) des Treibers (16) bildet, wobei die mindestens eine Diode (De) einen aus Störsignalen potentiell resultierenden Stromfluss von der Ansteuerelektrode (14) des Unterbrechungs-Halbleiterschalters (12) zum Highside-Schalter (20) und damit eine den Betrieb des Unterbrechungs-Halbleiterschalters (12) beeinträchtigende und insbesondere ein ungewolltes Öffnen des Unterbrechungs-Halbeiterschalters (12) verursachende Potentialverschiebung, insbesondere Mittelwertverschiebung, am Ausgangsanschluss (28) des Treibers (16) verhindert bzw. limitiert.
17. Elektronische Sicherung nach einer der Ziffern 1 bis 16, dadurch gekennzeichnet, dass in der vom Ausgangsanschluss (28) des Treibers (16) verlaufenden Ansteuerleitung (38) zwischen der Störunterdrückungs-Bauteilanordnung (SB) und der Ansteuerelektrode (14) des Unterbrechungs-Halbleiterschalters (12) ein ohmscher Widerstand (R₁) angeordnet ist.
18. Elektronische Sicherung nach einer der Ziffern 3, 8 oder 11 oder einem der vorhergehenden Ansprüche, sofern dieser auf Anspruch 3, 8 oder 11 rückbezogen ist, dadurch gekennzeichnet, dass der PMOS-Transistor (18) von einer Steuereinheit (32) der Vorrichtung zur Ansteuerung des Unterbrechungs-Halbleiterschalters (12) ansteuerbar ist und dass das Potential der n-Wanne des PMOS-Transistors (18) über die Steuereinheit (32) der Versorgung des Gate-Anschlusses (G) des PMOS-Transistors (18) dient.

### BEZUGSZEICHENLISTE

- 10: Vorrichtung
- 2: Unterbrechungs-Halbleiterschalter
- 14: Ansteuerelektrode
- 16: Treiber
- 18: PMOS-Transistor
- 18a: NMOS-Transistoren
- 18b: NMOS-Transistoren
- 20: Highside-Schalter
- 22: NMOS-Transistor
- 24: Lowside-Schalter
- 26: Verbindungsknoten
- 28: Treiberausgangsanschluss
- 30: Strombegrenzungswiderstand
- 32: Steuereinheit
- 34: Versorgungsleitung
- 38: Ansteuerleitung
- 40: Einheit
- 42: Masse
- C1: Kapazität
- D1: Diode bzw. Schottky-Diode
- D2: Diode bzw. Schottky-Diode
- D3: Diode bzw. Schottky-Diode
- D4: Diode bzw. Schottky-Diode
- D5: Diode
- D6: Diode
- R1: Widerstand
- R2: DC-Entladungswiderstand
- V1: Versorgungspannung
- A: Störpuls
- B: Störpuls
- B1: Platzhalter
- D: Drain (der Transistoren)
- G: Gate (der Transistoren)
- S: Source (der Transistoren)
- SB: Störunterdrückungs-Bauteilanordnungen

## Patentansprüche

1. Elektronische Sicherung für mindestens einen elektrischen Verbraucher insbesondere eines Fahrzeugs, mit
- mindestens einem Unterbrechungs-Halbleiterschalter (12) zur Unterbrechung der Zufuhr elektrischer Energie über eine Versorgungsleitung (34) zu einem Verbraucher (36) im Falle einer Störung des Verbrauchers (36), wobei der Unterbrechungs-Halbleiterschalter (12) eine Ansteuerelektrode (14) aufweist, und
- einer Vorrichtung zur Ansteuerung des Unterbrechungs-Halbleiterschalters (12), die versehen ist mit
- einem Treiber (16) für den Unterbrechungs-Halbleiterschalter (12), wobei der Treiber (16) einen elektrisch mit der Ansteuerelektrode (14) des Unterbrechungs-Halbleiterschalters (12) verbundenen Ausgangsanschluss (28) zur Lieferung einer DC-Ansteuerspannung für den Unterbrechungs-Halbleiterschalter (12) über eine zu dessen Ansteuerelektrode (14) führende Ansteuerleitung (38) aufweist,
- wobei der Treiber (16) ferner versehen ist mit einem Highside-Schalter (20), der zwischen einem Versorgungspotential (V₁) und dem Ausgangsanschluss (28) geschaltet ist, und mit einer zwischen dem Ausgangsanschluss (28) und Masse (42) geschalteten elektrischen und/oder elektronischen Einheit (40) zur zwecks Öffnens des Unterbrechungs-Halbleiterschalters (12) erfolgenden Ableitung eines Stroms von der Ansteuerelektrode (14) des Unterbrechungs-Halbleiterschalters (12), und
- mindestens einer elektrischen und/oder elektronischen Störunterdrückungs-Bauteilanordnung (SB) zur Verhinderung einer den Betrieb des Unterbrechungs-Halbleiterschalters (12) beeinträchtigenden und insbesondere ein ungewolltes Öffnen des Unterbrechungs-Halbleiterschalters (12) verursachenden Potentialveränderung, insbesondere Mittelwertverschiebung, am Ausgangsanschluss (28) des Treibers (16) als Folge von unsymmetrischen Reaktionen des Treibers (16) auf Störsignale, die über die Versorgungsleitung (34) des Verbrauchers einkoppelbar sind und/oder in der Versorgungsleitung (34) des Verbrauchers entstehen,
- wobei der Highside-Schalter (20) ein PMOS-Transistor (18) ist, der eine in einem Halbleitersubstrat ausgebildete n-dotierte n-Wanne mit einem Drain-Anschlussgebiet (D) und einem Source-Anschlussgebiet (S) aufweist und der mit einer Gate-Elektrode (G) versehen ist,
- wobei die Störunterdrückungs-Bauteilanordnung (SB) zur Erhöhung der Toleranz gegenüber Störsignalen, d.h. zur Erhöhung der Schaltschwelle bei am Ausgangsanschluss (28) des Treibers (16) anliegenden Störsignalen, zwei ggf. zusätzlich zum PMOS-Transistor (18) vorgesehene Dioden (D₂ und D₃) aufweist, die hinsichtlich ihrer Sperrrichtungen gegensinnig in Reihe geschaltet sind, wobei ihre Kathoden elektrisch miteinander sowie mit der n-Wanne des PMOS-Transistors (18) verbunden sind, und
- wobei der PMOS-Transistor (18) von einer Steuereinheit (32) der Vorrichtung zur Ansteuerung des Unterbrechungs-Halbleiterschalters (12) ansteuerbar ist und dass das Potential der n-Wanne des PMOS-Transistors (18) über die Steuereinheit (32) der Versorgung des Gate-Anschlusses (G) des PMOS-Transistors (18) dient.

2. Elektronische Sicherung für mindestens einen elektrischen Verbraucher insbesondere eines Fahrzeugs, mit
- mindestens einem Unterbrechungs-Halbleiterschalter (12) zur Unterbrechung der Zufuhr elektrischer Energie über eine Versorgungsleitung (34) zu einem Verbraucher (36) im Falle einer Störung des Verbrauchers (36), wobei der Unterbrechungs-Halbleiterschalter (12) eine Ansteuerelektrode (14) aufweist, und
- einer Vorrichtung zur Ansteuerung des Unterbrechungs-Halbleiterschalters (12), die versehen ist mit
- einem Treiber (16) für den Unterbrechungs-Halbleiterschalter (12), wobei der Treiber (16) einen elektrisch mit der Ansteuerelektrode (14) des Unterbrechungs-Halbleiterschalters (12) verbundenen Ausgangsanschluss (28) zur Lieferung einer DC-Ansteuerspannung für den Unterbrechungs-Halbleiterschalter (12) über eine zu dessen Ansteuerelektrode (14) führende Ansteuerleitung (38) aufweist,
- wobei der Treiber (16) ferner versehen ist mit einem Highside-Schalter (20), der zwischen einem Versorgungspotential (V₁) und dem Ausgangsanschluss (28) geschaltet ist, und mit einer zwischen dem Ausgangsanschluss (28) und Masse (42) geschalteten elektrischen und/oder elektronischen Einheit (40) zur zwecks Öffnens des Unterbrechungs-Halbleiterschalters (12) erfolgenden Ableitung eines Stroms von der Ansteuerelektrode (14) des Unterbrechungs-Halbleiterschalters (12), und
- mindestens einer elektrischen und/oder elektronischen Störunterdrückungs-Bauteilanordnung (SB) zur Verhinderung einer den Betrieb des Unterbrechungs-Halbleiterschalters (12) beeinträchtigenden und insbesondere ein ungewolltes Öffnen des Unterbrechungs-Halbleiterschalters (12) verursachenden Potentialveränderung, insbesondere Mittelwertverschiebung, am Ausgangsanschluss (28) des Treibers (16) als Folge von unsymmetrischen Reaktionen des Treibers (16) auf Störsignale, die über die Versorgungsleitung (34) des Verbrauchers einkoppelbar sind und/oder in der Versorgungsleitung (34) des Verbrauchers entstehen,
- wobei der Highside-Schalter (20) ein PMOS-Transistor (18) ist, der eine in einem Halbleitersubstrat ausgebildete n-dotierte n-Wanne mit einem Drain-Anschlussgebiet (D) und einem Source-Anschlussgebiet (S) aufweist und der mit einer Gate-Elektrode (G) versehen ist,
- wobei die Störunterdrückungs-Bauteilanordnung (SB) zur Erhöhung der Toleranz gegenüber Störsignalen, d.h. zur Erhöhung der Schaltschwelle bei am Ausgangsanschluss (28) des Treibers (16) anliegenden Störsignalen, eine erste Diode (D₄), insbesondere eine Schottky-Diode aufweist, deren Kathode mit der n-Wanne und deren Anode mit dem Source-Anschlussgebiet (S) des PMOS-Transistors (18) verbunden ist, und
- wobei der PMOS-Transistor (18) von einer Steuereinheit (32) der Vorrichtung zur Ansteuerung des Unterbrechungs-Halbleiterschalters (12) ansteuerbar ist und dass das Potential der n-Wanne des PMOS-Transistors (18) über die Steuereinheit (32) der Versorgung des Gate-Anschlusses (G) des PMOS-Transistors (18) dient.

3. Elektronische Sicherung für mindestens einen elektrischen Verbraucher insbesondere eines Fahrzeugs, mit
- mindestens einem Unterbrechungs-Halbleiterschalter (12) zur Unterbrechung der Zufuhr elektrischer Energie über eine Versorgungsleitung (34) zu einem Verbraucher (36) im Falle einer Störung des Verbrauchers (36), wobei der Unterbrechungs-Halbleiterschalter (12) eine Ansteuerelektrode (14) aufweist, und
- einer Vorrichtung zur Ansteuerung des Unterbrechungs-Halbleiterschalters (12), die versehen ist mit
- einem Treiber (16) für den Unterbrechungs-Halbleiterschalter (12), wobei der Treiber (16) einen elektrisch mit der Ansteuerelektrode (14) des Unterbrechungs-Halbleiterschalters (12) verbundenen Ausgangsanschluss (28) zur Lieferung einer DC-Ansteuerspannung für den Unterbrechungs-Halbleiterschalter (12) über eine zu dessen Ansteuerelektrode (14) führende Ansteuerleitung (38) aufweist,
- wobei der Treiber (16) ferner versehen ist mit einem Highside-Schalter (20), der zwischen einem Versorgungspotential (V₁) und dem Ausgangsanschluss (28) geschaltet ist, und mit einer zwischen dem Ausgangsanschluss (28) und Masse (42) geschalteten elektrischen und/oder elektronischen Einheit (40) zur zwecks Öffnens des Unterbrechungs-Halbleiterschalters (12) erfolgenden Ableitung eines Stroms von der Ansteuerelektrode (14) des Unterbrechungs-Halbleiterschalters (12), und
- mindestens einer elektrischen und/oder elektronischen Störunterdrückungs-Bauteilanordnung (SB) zur Verhinderung einer den Betrieb des Unterbrechungs-Halbleiterschalters (12) beeinträchtigenden und insbesondere ein ungewolltes Öffnen des Unterbrechungs-Halbleiterschalters (12) verursachenden Potentialveränderung, insbesondere Mittelwertverschiebung, am Ausgangsanschluss (28) des Treibers (16) als Folge von unsymmetrischen Reaktionen des Treibers (16) auf Störsignale, die über die Versorgungsleitung (34) des Verbrauchers einkoppelbar sind und/oder in der Versorgungsleitung (34) des Verbrauchers entstehen,
- wobei der Highside-Schalter (20) ein PMOS-Transistor (18) ist, der eine in einem Halbleitersubstrat ausgebildete n-dotierte n-Wanne mit einem Drain-Anschlussgebiet (D) und einem Source-Anschlussgebiet (S) aufweist und der mit einer Gate-Elektrode (G) versehen ist,
- wobei die Störunterdrückungs-Bauteilanordnung (SB) zur Erhöhung der Toleranz gegenüber Störsignalen, d.h. zur Erhöhung der Schaltschwelle bei am Ausgangsanschluss (28) des Treibers (16) anliegenden Störsignalen, eine Zener-Diode (D₄) aufweist, deren Kathode mit der n-Wanne und deren Anode mit dem Source-Anschlussgebiet (S) des PMOS-Transistors (18) verbunden ist, und
- wobei der PMOS-Transistor (18) von einer Steuereinheit (32) der Vorrichtung zur Ansteuerung des Unterbrechungs-Halbleiterschalters (12) ansteuerbar ist und dass das Potential der n-Wanne des PMOS-Transistors (18) über die Steuereinheit (32) der Versorgung des Gate-Anschlusses (G) des PMOS-Transistors (18) dient.

4. Elektronische Sicherung nach einem der Ansprüche 1 bis 3, **dadurch gekennzeichnet, dass** mindestens eine der beiden Dioden (D₂, D₃) als parasitäre Diode zwischen einerseits dem Drain-Anschlussgebiet (D) oder dem Source-Anschlussgebiet (S) des PMOS-Transistors (18) und andererseits dessen n-Wanne ausgebildet ist.

5. Elektronische Sicherung nach einem der Ansprüche 1 bis 3, **dadurch gekennzeichnet, dass** mindestens eine der beiden Dioden (D₂, D₃) als Schottky-Dioden ausgeführt ist.

6. Elektronische Sicherung nach einem der Ansprüche 1 bis 5, **dadurch gekennzeichnet, dass** parallel zu einer der beiden Dioden (D₂, D₃) zwischen der n-Wanne des PMOS-Transistors (18) und dessen Drain-Anschlussgebiet (D) bzw. zwischen der n-Wanne des PMOS-Transistors (18) und dem Versorgungspotential (V₁) ein ohmscher Widerstand (R₂) zur Vermeidung von Aufladungen der n-Wanne des PMOS-Transistors (18) geschaltet ist.

7. Elektronische Sicherung nach Anspruch 4 oder 5, **dadurch gekennzeichnet, dass** parallel zu einer der beiden Dioden (D₂, D₃) zwischen der n-Wanne des PMOS-Transistors (18) und Masse (42) ein ohmscher Widerstand (R₂) zur Vermeidung von Aufladungen der n-Wanne geschaltet ist.

8. Elektronische Sicherung nach einem der Ansprüche 1 bis 3, **dadurch gekennzeichnet, dass** zur Begrenzung von Spannungshüben in der n-Wanne des PMOS-Transistors (18) zwischen dieser und dem Source-Anschlussgebiet (S) des PMOS-Transistors (18) eine antiparallel zur ersten Diode (D₄) angeordnete weitere Diode (D₅) geschaltet ist.

9. Elektronische Sicherung nach Anspruch 8, **dadurch gekennzeichnet, dass** zum DC-Potentialausgleich der Versorgungsspannung V₁ parallel zur ersten Diode (D₄) ein Widerstand (R₂) geschaltet ist.

10. Elektronische Sicherung nach einem der Ansprüche 1 bis 3, **dadurch gekennzeichnet, dass** zwischen einerseits der n-Wanne des PMOS-Transistors (18) und andererseits einem seiner Anschlüsse (S, D) oder dem Versorgungspotential (V₁) oder der Masse (42) zur Vermeidung von Aufladungen der n-Wanne ein ohmscher Widerstand geschaltet ist.

11. Elektronische Sicherung nach Anspruch 10, **dadurch gekennzeichnet, dass** zwischen dem Ausgangsanschluss (28) des Treibers (16) und der n-Wanne des PMOS-Transistors (18) eine Diode (D₃), insbesondere eine Schottky-Diode geschaltet ist, deren Kathode mit der n-Wanne des PMOS-Transistors (18) verbunden ist.

12. Elektronische Sicherung nach einem der Ansprüche 1 bis 11, **dadurch gekennzeichnet, dass** in der vom Ausgangsanschluss (28) des Treibers (16) verlaufenden Ansteuerleitung (38) zwischen der Störunterdrückungs-Bauteilanordnung (SB) und der Ansteuerelektrode (14) des Unterbrechungs-Halbleiterschalters (12) ein ohmscher Widerstand (R₁) angeordnet ist.
